# EUROPEAN PATENT APPLICATION

(11) **EP 1 482 339 A1**
(43) Date of publication of application: **01.12.2004**
(21) Application number: 04011861.4
(22) Date of filing: 19.05.2004
(51) Int. Cl.: G02B 6/42

(54) **Optical module, method of manufacturing the same, optical communication device and electronic device using the same**

(30) Priority: 27.05.2003 JP 2003149860
(71) Applicant: Seiko Epson Corporation, Shinjuku-ku, Tokyo 163-0811 (JP)
(72) Inventor: Miyamae, Akira Seiko Epson Corporation, Suwa-shi Nagano-ken 392-8502 (JP); Nagasaka, Kimio Seiko Epson Corporation, Suwa-shi Nagano-ken 392-8502 (JP)
(74) Representative: Hoffmann, Eckart, Dipl.-Ing.

(57) **Abstract**

An optical module (1) comprises: a substrate (10) with an aperture (11) into which an optical fiber (2) is detachably inserted; a printed circuit board (13) disposed on one surface side of the substrate (10) and comprising: a base member (14) with an opening (20) in a location corresponding to the aperture (11); an interconnection layer (15) at least on one surface side of the base member (14); and a connection section (21) comprising a part of the interconnection layer (15) exposed through the opening (20); and an electro-optical element (12) disposed within the opening (20) of the printed circuit board (13) and connecting to the connection section (21) for performing transmission or reception of an optical signal through the optical fiber (2).

## Description

The present invention relates to an optical module suitable for use in optical communication systems; the invention also relates to a manufacturing method of the optical module.

Optical communication systems have basic configurations in which light emitting elements for converting an electrical signal to an optical signal and light receiving elements for converting an optical signal to an electrical signal are connected through optical fibers. In order to detachably connect such electro-optical elements, light emitting elements or light receiving elements, with optical fibers, optical modules for optically connecting electro-optical elements to optical fibers are used. Such optical modules are described in various documents such as JP 2000-349307 A, for example.

Since the optical modules mentioned above have a structure in which a substrate is interposed between an electro-optical element and an optical fiber, a gap of at least the thickness of the substrate exists between the electro-optical element and the optical fiber. Therefore, light coupling losses between the electro-optical element and the optical fiber are easy to occur and high accuracy is required for the alignment thereof. Further, interconnection layers for transferring signals to or from the electro-optical elements are provided by patterning conductive films formed on the substrates, which increases the manufacturing cost because it is not so easy to pattern the conductive material on such a three-dimensional shape.

An object of the present invention is to provide an optical module capable of increasing the light coupling efficiency. Another object of the present invention is to provide an optical module capable of reducing the manufacturing cost.

These objects are achieved by an optical module according to a first, second and third aspect of the invention as claimed in claims 1, 6 and 7, respectively, a method as claimed in claims 10, 13 and 15 and preferred embodiments and uses as claimed in the dependent claims.

With the optical module according to the first aspect of the present invention, since a flexible printed circuit board having an interconnection layer is used, it is not necessary to pattern an interconnection layer on the substrate, thereby reducing the manufacturing cost and accordingly reducing the total cost of the optical module. Further, since the electro-optical element is disposed on the connecting section (so called flying leads) exposed through the opening provided in the printed circuit board, the distance between the electro-optical element and the optical fiber can be reduced, thus enhancing the light coupling efficiency. It is advantageous that the alignment margin is expanded due to the increased light coupling efficiency.

It is preferable to provide on the printed circuit board an electronic component to form an electronic circuit with the electro-optical element. Here, "electronic component" denotes, for example, a driver for driving a light emitting element as the electro-optical element, an amplifier for amplifying an output signal of a light receiving element as the electro-optical element, various other circuit chips, or passive components such as a resistors or capacitors, or various other active components or passive components. By providing various electronic components involved in the operation of the electro-optical element, it is possible to eliminate or simplify an external drive circuit or the like. Further, since the length of the interconnection between the electro-optical element and a circuit chip such as a driver can be shortened, it is expected that problems such as delays in signals and interfusion of noises can easily be avoided.

With the optical module according to the second aspect of the invention, it is also possible to reduce the manufacturing cost and accordingly to reduce the total cost of the optical module. Further, the distance between the electro-optical element and the optical fiber can be reduced, thus enhancing the light coupling efficiency. Still further, by taking the structure in which the electro-optical element is disposed in the space provided by the aperture for disposition of the component and is supported by the flexible printed circuit board disposed so as to cover the aperture, it is possible to achieve further downsizing of the optical module.

The optical module according to the second aspect is preferably equipped with a light guide on the other surface side (opposite to the substrate) of the flexible printed circuit board for transmitting or receiving an optical signal to or from the electro-optical element. Here, "light guide" has no limitation as to the structure as long as it can transfer the light signal in a required direction, and as examples, a member having a core/clad structure using two media having different refractive index from each other like an optical fiber, or a member utilizing a photonic crystal are applicable. Further, the light guide (a planar type light guide) to be disposed so that an extension direction thereof is substantially parallel to one direction of the substrate is preferably adopted.

Note that the further preferable conditions for the optical module according to the second aspect are basically the same as those for the optical module according to the first aspect. In particular, substantially the same conditions regarding the alignment member, the sealing member, the electronic components, and so on can be adopted.

With the optical module according to the third aspect of the present invention it is also possible to reduce the manufacturing cost and accordingly to reduce the total cost of the optical module. Further, the distance between the electro-optical element and the optical fiber can be reduced, thus enhancing the light coupling efficiency.

The optical module according to the third aspect is preferably equipped with a light guide on the other surface side of the transparent substrate that transmits or receives an optical signal to or from the electro-optical element. Further, a sleeve or the like for supporting the optical fiber is preferably provided. The further preferable conditions for the optical module according to the third aspect are basically the same as those for the optical module according to the first aspect. In particular, substantially the same conditions regarding the alignment member, the sealing member, the electronic components, and so on can be adopted.

An optical module in accordance with the present invention is applicable to an optical communication device (an optical transceiver). Such an optical communication device can be applied to various electronic devices that exchange information with external devices using light as a transmission medium, such as personal computers or so-called PDAs (portable information terminal devices), for example. Note that in the present specification "optical communication device" denotes not only a device including both of a configuration regarding transmission of an optical signal (a light emitting element or the like) and a configuration regarding reception of an optical signal (a light receiving element or the like), but also a device equipped only with the configuration regarding transmission (so-called optical transmission module) and a device equipped only with the configuration regarding reception (so-called optical reception module).

Hereinafter, preferred embodiments of the present invention are described in more detail with reference to the accompanying drawings, in which:
- FIG. 1: is a schematic view of an optical module according to a first embodiment;
- FIG. 2: is a schematic illustration of steps of a manufacturing method of an optical module according to a first embodiment;
- FIG. 3: is a schematic view of an optical module according to a second embodiment;
- FIG. 4: is a schematic illustration of steps of a manufacturing method of an optical module according to a second embodiment;
- FIG. 5: is a schematic view of an optical module according to a third embodiment;
- FIG. 6: is a schematic illustration of steps of a manufacturing method of an optical module according to a third embodiment;
- FIG. 7: is a schematic view of another structure of an optical module.

### First Embodiment

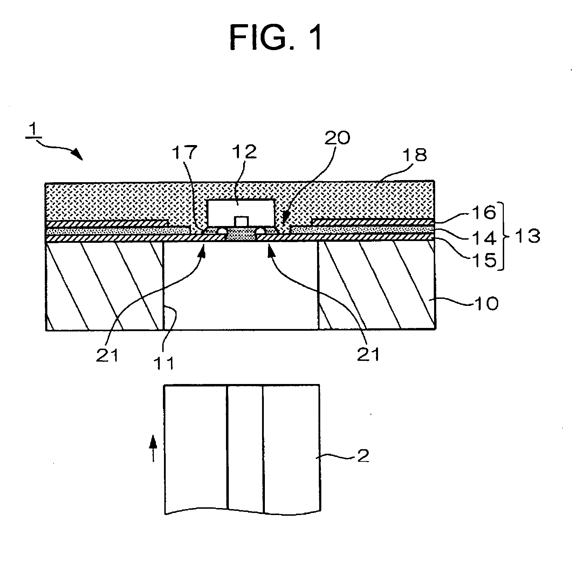

FIG. 1 is a schematic cross-sectional view of an optical module according to a first embodiment of the present invention. The optical module 1 shown in FIG. 1 comprises a substrate 10, an electro-optical element 12 (more particularly, an optical-to-electrical converter or an electrical-to-optical converter), a flexible printed circuit (FPC) board 13, an underfill member 17, and a sealing member 18. The optical module 1 is configured, as shown in the figure, so that an optical fiber 2 is detachably inserted in an aperture 11 provided in the substrate 10.

The substrate 10 supports each of the elements forming the optical module 1 and is equipped with the aperture 11 for the optical fiber 2. The substrate 10 can be made of various materials including conductive materials such as stainless steel, aluminum, or copper or nonconductive materials such as glass, resin, or ceramics. In the present embodiment the substrate 10 is made of ceramics, for example.

The electro-optical element 12 is disposed above the aperture 11 and inside an opening 20 provided in the FPC board 13, and transmits an optical signal (emits light) toward the optical fiber 2 or receives an optical signal (receives light) emitted from the optical fiber 2 through the FPC board 13. If, for example, the optical module 1 is used on an information transmission side, a light emitting element such as a VCSEL (vertical cavity surface emitting laser) may be used as the electro-optical element 12. If the optical module 1 is used on an information reception side, a light receiving element is used as the electro-optical element.

The FPC board 13 is disposed on one surface side (the upper surface side in the figure) of the substrate 10 and comprises a base member 14 having the opening 20 at a location corresponding to the aperture 11, a first interconnection layer 15 disposed on one surface side (the side facing the substrate 10) of the base member 14, and a second interconnection layer 16 disposed on the other surface side of the base member 14. Further, the FPC board 13 includes, as shown in the figure, a connection section 21 that is formed by exposing a part of the first interconnection layer through the opening 20. The first interconnection layer 15 and the electro-optical element 12 are electrically connected in the connection section 21. Such a structure as the connection section 21 is commonly called "flying lead".

The base member 14 functions as a base of the FPC board 13, and is made of a resin film such as a polyimide film or an epoxy film. In view of flexibility and ease of handling, a polyimide film is preferably used.

The first interconnection layer 15 is used for electrical signal transmission between the electro-optical element 12 connected in the connection section 21 and an electronic component such as a circuit chip not shown in the figure, and is disposed on one surface side of the base member 14. The interconnection layer is formed in a predetermined shape (an interconnection pattern) using a conductive material such as copper.

The second interconnection layer 16 is used for signal transmission between the electro-optical element 12 and an electronic component such as a circuit chip not shown in the figure, and is formed on the other surface of the base member 14 as a predetermined shape (an interconnection pattern) using a conductive material such as copper.

In order to allow a high-speed operation of the electro-optical element 12, a microstrip line is preferably formed of the base member 14, the first interconnection layer 15, and the second interconnection layer 16. Details are described further below.

The underfill member (the alignment member) 17 is interposed between the electro-optical element 12 and an area defined by the aperture 11, and is used to suppress reflection and dispersion of the optical signal in that position to reduce light loss. Thus, unnecessary reflection is suppressed to enhance the light coupling efficiency. In the present embodiment, the underfill member 17 is made of a material having an index of refraction similar to (more preferably substantially the same as) that of the core of the optical fiber 2 that is inserted into the aperture 11. In view of the manufacturing process, the underfill member 17 is made of a material that can first be filled and subsequently cured, such as epoxy resin having thermosetting property or photo-curing property.

The sealing member 18 is for protecting the electro-optical element 12 and is disposed on the FPC board 13 so as to tightly seal the whole of the electro-optical element 12. In the example shown in the figure, the sealing member 18 is provided so as to cover substantially the whole of the FPC board 13. However, the sealing member is not limited to a form like this. The sealing member may be provided partially so as to seal at least the electro-optical element 12. Like the underfill member 17, the sealing member (potting member) 18 is preferably made of a material that can first be deposited and subsequently cured, such as epoxy resin having thermosetting property or photo-curing property. Further, the sealing member is preferably made of the same material as the underfill member 17. Thus, adhesion of the underfill member 17 to the sealing member 18 can be enhanced. In this case, the underfill member 17 and the sealing member 18 can be formed in one batch.

A process for forming the microstrip line including the base member 14, the first interconnection layer 15, and the second interconnection layer 16 is described next in detail. The characteristic impedance of the microstrip line formed in such a manner can be set to a desired value based on the following equation. That is, assuming that the width of the transmission line (the first interconnection layer 15) is B, the thickness of the line is C, the distance between the transmission line and the ground (the second interconnection layer used to apply the ground potential) is H, the specific dielectric constant of the base member 14 (the dielectric layer) is εᵣ, the characteristic impedance Z0 of the microstrip line is given by the following equation:${\text{Z0 = (87 / (ε}}_{\text{r}} {\text{+ 1.41)}}^{\text{½}} \text{) x In(5.98H / (0.8B+C))}$

If the input/output impedance of the electro-optical element 12 is 50Ω, the characteristic impedance of the microstrip line should be set to 50Ω to make the impedances match each other preventing the signal from decaying. For example, by using a polyimide film having a specific dielectric constant εᵣ = 3.4 as the base member 14, and setting the other parameters as follows: B = 0.09 mm; H = 0.05 mm; and C = 0.012 mm, the characteristic impedance Z0 of the microstrip line can be set to approximately 50Ω. If the thickness of the base member 14 is thinner than 0.05 mm, the width of the conductive line becomes too narrow resulting in an increased DC resistance or a fluctuation in the impedance value caused by variation of the line width.

The optical module 1 according to the present embodiment has the structure described above. A method of manufacturing the optical module 1 is described next.

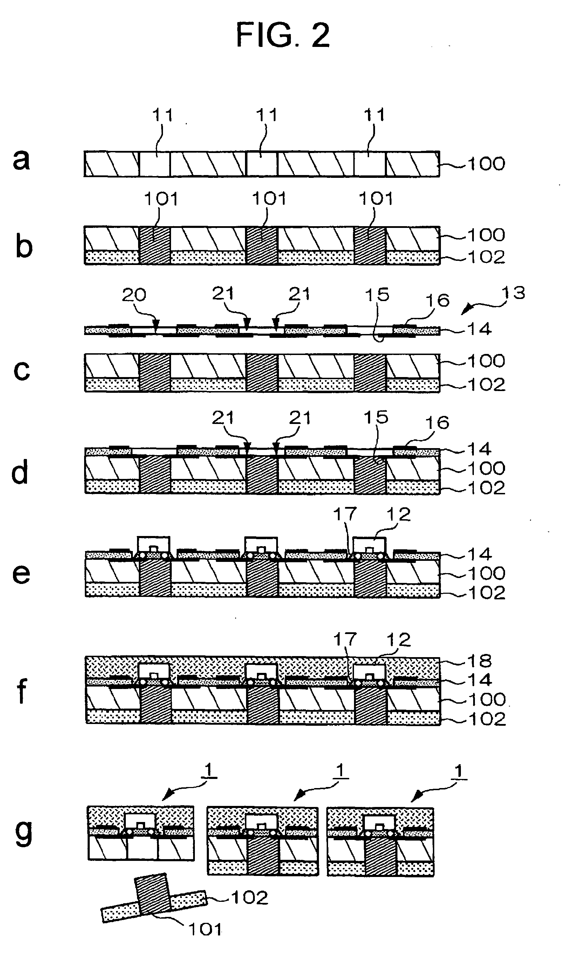

FIG. 2 is a schematic illustration of various steps of the manufacturing method according to the present embodiment. In this embodiment, a number of optical modules each identical to the optical module 1 are formed on one parent substrate in a batch, and then the parent substrate is divided into the individual optical modules that are hereinafter also denoted as 1. The details are described below.

Firstly, as shown in FIG. 2a, a parent substrate 100 that will later become the substrates 10 of the optical modules 1 is provided. The parent substrate 100 is provided with a plurality of apertures 11 corresponding to the areas where the respective optical modules 1 will be formed. In this case, if a ferrule is attached to the optical fiber 2 later to be inserted into a respective aperture 11, the aperture 11 is formed with a diameter suitable for the diameter of the ferrule.

Then, as shown in FIG. 2b, a respective pin 101 (a supporting member), as a jig, is inserted into each aperture 11. The pins 101 are used to support the connection sections from the reverse side when the electro-optical elements 12 are mounted in a later process. The material of the pins 101 is not critical but a metal is preferably used. In the present embodiment, one end surface of the pins 101 and one surface of the parent substrate 100 are polished at the same time to obtain a smooth plane. Alternately, the one end surface (the surface exposed to the one surface of the parent substrate 100) of the pins 101 is made substantially flat, and the pins 101 are then inserted into the parent substrate 100 while aligning their position so that the flat surface of the pins 101 is aligned with the one surface of the parent substrate 100. As shown in the figure, in the present embodiment, the other end of the pins 101 protrudes from the other surface of the parent substrate 100, and is fixed with resin 102. However, if the fixing strength of the pins 101 is sufficient, for example, in case these pins 101 are press fitted into the aperture 11, the resin 102 is omissible.

Then, as shown in FIG. 2c, each opening 20 of the FPC board 13 is aligned with a corresponding one of the apertures 11 of the parent substrate 100. After that, as shown in FIG. 2d, the FPC board 13 is attached on the parent substrate 100. An epoxy adhesive is used to fix the FPC board 13 to the parent substrate 100. In the present embodiment, the FPC board 13 forming a microstrip line is used.

Then, as shown in FIG. 2e, each of the plurality of electro-optical elements 12 is disposed on a respective one of the openings 20 of the FPC board 13, and then connected to the respective connection section 21. Each of the electro-optical elements 12 is mounted on the connection section 21 with the respective light emitting or receiving surface facing toward the aperture 11. In the present process, the electro-optical element 12 and the connection section 21 are connected by, for example, flip-chip bonding. In this case, a solder bump necessary for the flip-chip bonding can be formed on either of the electro-optical element side or the connection section side. However, if the solder bump is formed on the connection section side, handling of the electro-optical element 12 (an operation performed by an assembly robot such as absorption) becomes easier.

In the present process, since the openings 20 of the base member 14 are broader than the electro-optical elements 12, the electro-optical elements 12 are inserted into the respective openings 20. Since the connection sections 21 are supported from below by the respective pins 101, the connection sections 21 are prevented from being deformed or broken when the electro-optical elements 12 are mounted, and the electro-optical elements 12 can easily and surely be mounted. In the present process, other electronic components (for example, a driver for driving the electro-optical element 12) can be mounted on the FPC board 13 if required.

Then, as shown in FIG. 2e, the underfill members 17 for reducing the light loss are filled into the space between each electro-optical element 12 (more exactly, the light emitting surface of the electro-optical element) and the aperture 11. In the present process, the material for the underfill members, for example, transparent epoxy resin, is filled into that space and then hot-cured.

Then, as shown in FIG. 2f, the sealing members 18 are formed so that the whole of each electro-optical element 12 is tightly sealed. As sealing member 18, for example, thermosetting epoxy resin can be used. It is possible to form the sealing members 18 and the underfill members 17 in a batch from the same material, to simplify the manufacturing process. As described above, the sealing members 18 can be partially formed only in an area adjacent to each of the electro-optical elements 12. The sealing members 18 can preferably be provided on substantially the whole area of the one surface side of the parent substrate 100 as in the present embodiment, to further simplify the manufacturing process.

Then, as shown in FIG. 2g, the parent substrate 100 and other necessary members are divided into predetermined pieces corresponding to the individual optical modules 1. Dicing or laser cutting can be used for the dividing process. And then, after removing the pins 101 and the resin 102 a plurality of optical modules 1 are obtained.

As described above, in the optical module 1 of the present embodiment it is not necessary to pattern an interconnection layer on the substrate 10 because the FPC board 13 having interconnection layers 15 and 16 is used, thus reducing the production cost and accordingly reducing the total cost of the optical modules. Furthermore, since the electro-optical element 12 is disposed on the connection section 21 (so-called flying lead) exposed through the opening 20 provided in the FPC board 13, the distance between the optical fiber 2 and the electro-optical element 12 can be shortened, thus enhancing the light coupling efficiency. Since the light coupling efficiency is enhanced, the alignment margin is advantageously increased.

The optical module 1 according to the present embodiment can preferably be applied to an optical communication device (an optical transceiver). The optical communication device according to the present invention can be applied to personal computers, PDAs (portable information terminal devices), personal digital assistants, or various other electronic devices.

### Second Embodiment

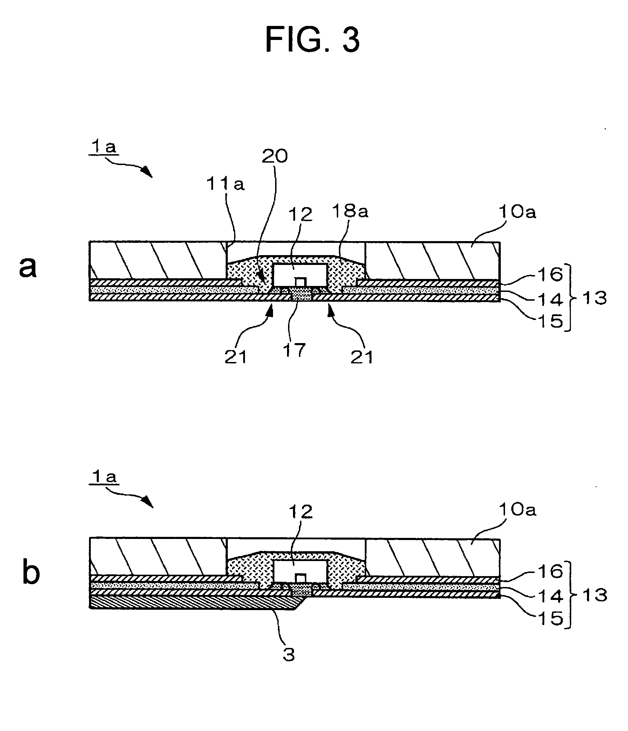

FIG. 3 is a schematic cross-sectional view of an optical module according to a second embodiment. In the optical module 1 a shown in the figure, the same reference numerals are used for components that are common to the optical module 1 according to the first embodiment. Note that the detailed description for the common components is omitted here.

The optical module 1a shown in FIG. 3a comprises a substrate 10a, the electro-optical element 12, the FPC board 13, the underfill member 17, and a sealing member 18a. The optical module 1a as shown in FIG. 3b, performs transmission of an optical signal to or reception of an optical signal from a light guide 3 disposed on the other surface of the FPC board 13. Alternatively, the optical module 1a can be used in combination with an opto-electronic mixed board equipped with a light guide.

The substrate 10a supports each of the components forming the optical module 1a and is provided with an aperture 11 a for defining a space in which the electro-optical element 12 is disposed. In an example shown in the figure, the aperture 11 a is a through-hole in the substrate 10a, but it need not necessarily be a through-hole but can be a recess or hollow. Materials suitable for the substrate 10a are the same as those in the first embodiment. In the present embodiment the substrate 10a is made of, for example, ceramics.

The electro-optical element 12 is disposed inside the aperture 11 and inside the opening 20 provided in the FPC board 13, and transmits or receives the optical signal through the FPC board 13.

The FPC board 13 comprises a base member 14 having the opening 20 at a location corresponding to the aperture 11a, a first interconnection layer 15 disposed on one surface side (the side facing away from the substrate 10a) of the base member 14, and a second interconnection layer 16 disposed on the other surface side (the side facing the substrate 10a) of the base member 14, and is disposed on one surface side (lower surface side as viewed in the figure) of the substrate 10a. Further, the FPC board 13 includes, as shown in the figure, a connection section 21 that is formed by exposing a part of the first interconnection layer through the opening 20. The first interconnection layer 15 and the electro-optical element 12 are electrically connected in the connection section 21.

The sealing member 18a is for protecting the electro-optical element 12 and is disposed inside the aperture 11a and on the FPC board 13 so as to tightly sealing the whole of the electro-optical element 12.

The manufacturing method according to the present embodiment is basically the same as the manufacturing method according to the first embodiment. Therefore, the description hereinafter is mainly focused on the differences between the two.

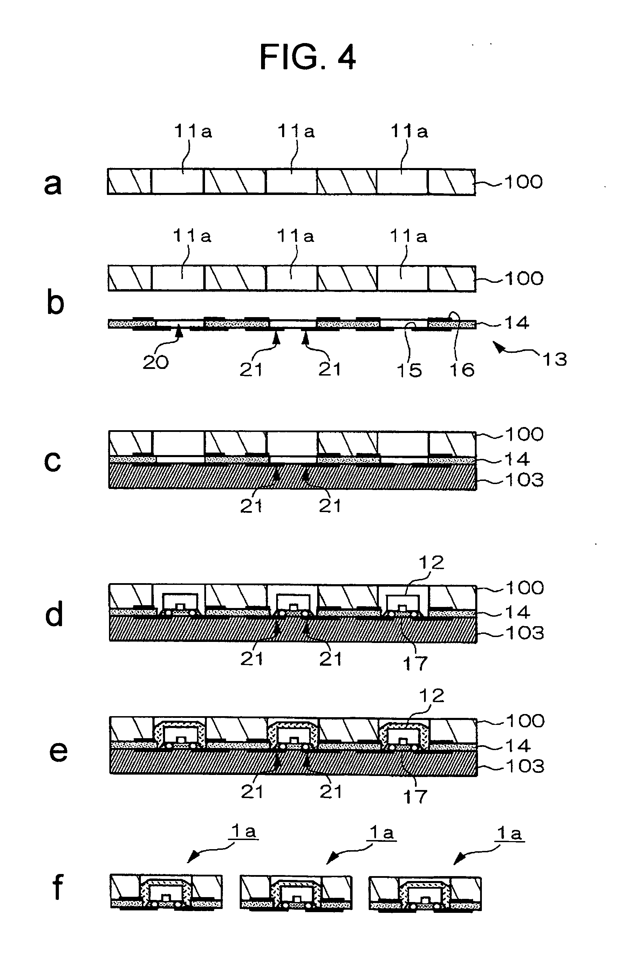

FIG. 4 illustrates various steps of the manufacturing method of the optical module according to the second embodiment. Firstly, as shown in FIG. 4a, a parent substrate 100 that will later become the substrates 10a of the optical modules 1a is provided. A plurality of apertures 11 a is provided in the parent substrate 100, each aperture corresponding to an area where a respective one of the optical modules 1a will be formed.

Then, as shown in FIG. 4b, each opening 20 of the FPC board 13 is aligned with a corresponding one of the apertures 11a of the parent substrate 100. After that, as shown in FIG. 4c, the FPC board 13 is attached on the parent substrate 100. In the present embodiment, an FPC board 13 with a microstrip line is used.

Further, as shown in FIG. 4c, a dummy substrate 103 is disposed as a jig on the other surface side (the side remote from the parent substrate 100) of the FPC board 13. The dummy substrate 103 has at least one substantially flat surface, and is used to support the FPC board 13 from behind when the electro-optical elements 12 are mounted in the subsequent process. There is no limitation to the material that may be used for the dummy substrate 103, but metal or glass is preferably used. In the present embodiment, a SUS (stainless steel) substrate is used as the dummy substrate 103. Further, the dummy substrate 103 is preferably fixed to the parent substrate 100 by screw cramping or the like. Note that in the present process the dummy substrate 103 can be omitted provided at least the connection sections 21 are supported by a flat surface. However, by using the dummy substrate 103, the electro-optical elements 12 can easily be mounted.

Then, as shown in FIG. 4d, each of the electro-optical elements 12 is disposed in a respective one of the openings 20 of the FPC board 13, and then connected to the respective connection section 21. Then, the underfill member 17 for reducing the light loss is filled in between the electro-optical element 12 and the connection section 21. In this case, each of the electro-optical elements 12 is mounted on the respective connection section 21 with its light emitting or receiving surface facing toward the outside of the substrate 10a. In the present process, the electro-optical elements 12 are connected with the connection sections 21 of the first interconnection layer 15 by flip-chip bonding.

In the present process, since the openings 20 of the base member 14 are broader than the electro-optical elements 12, the electro-optical elements 12 are inserted into the openings 20, respectively. Since the connection sections 21 are supported from below by the dummy substrate 103, the connection sections 21 are prevented from being deformed or broken when the electro-optical elements 12 are mounted, and the electro-optical elements 12 can easily and surely be mounted. In the present process, other electronic components (for example, a driver for driving the electro-optical element 12) can be mounted on the FPC board 13 if required.

Then, as shown in FIG. 4e, the sealing members 18a are formed so that the whole of the electro-optical elements 12 is tightly sealed. As sealing member 18a, for example, thermosetting epoxy resin can be used. It is possible to form the sealing members 18a and the underfill members 17 in a batch from the same material.

Then, as shown in FIG. 4f, after removing the dummy substrate 103, the parent substrate 100 and other necessary members are divided into predetermined pieces corresponding to the individual optical modules 1a. Dicing or laser cutting can be used for the dividing process. Thus, a plurality of optical modules 1a can be obtained.

As described above, the optical module 1a according to the second embodiment, in the same manner as the first embodiment, is able to reduce the total cost of the optical module by reducing the manufacturing cost, and also to enhance the light coupling efficiency by reducing the distance between the optical fiber and the electro-optical element. Furthermore, the electro-optical element 12 is disposed in the space defined by the aperture 11a. Also, the electro-optical element 12 is supported by the FPC board 13 disposed so as to cover the aperture 11a. By adopting such a structure, further downsizing of the optical module 1a is possible. The optical module 1a according to the present embodiment can also be applied to an optical transceiver or various electronic devices as well.

### Third Embodiment

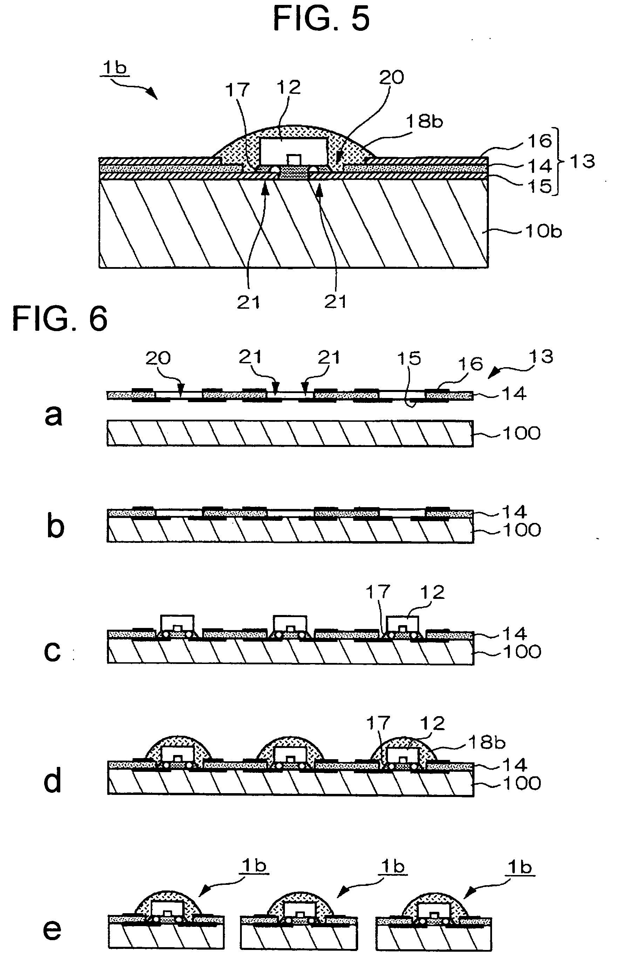

FIG. 5 is a schematic cross-sectional view of an optical module according to a third embodiment. In the optical module 1b shown in the figure, the same reference numerals are used for components that are common to the optical module 1 according to the first embodiment. Note that the detailed description for the common components is omitted here.

The optical module 1b shown in the figure is equipped with basically the same components as the optical module 1 according to the first embodiment. The major difference is that the aperture 11 into which the optical fiber 2 is inserted is omitted. More specifically the optical module 1b comprises a transparent substrate 10b, the FPC board 13, the underfill member 17, and a sealing member 18b. This optical module 1b is equipped with optical components such as a lens or a mirror on the other surface side, i.e., the surface side remote from the substrate 10b. Further, a light guide for transmitting or receiving an optical signal to or from the electro-optical element is also provided, or the optical module 1b is used in combination with an opto-electronic mixed board equipped with such a light guide. Further, a sleeve for supporting the optical fiber can be provided on the other surface side of the substrate 10b, and further a lens can be provided at either the other side of the substrate 10b or on the substrate side of the sleeve side.

The substrate 10b supports each of the components forming the optical module 1b, and is made of a material having transparency. This substrate 10b need to have a high transmission factor only in a wavelength range of the target optical signal, and a glass substrate, a plastic substrate or the like can be used.

The electro-optical element 12 is disposed inside the opening 20 provided in the FPC board 13, and transmits the optical signal (emits light) to the outside or receives the optical signal (receives light) from the outside through the FPC board 13 and the substrate 10b. The electro-optical element 12 is connected to the connection section 21 provided by exposing a part of the first interconnection layer 15 through the opening 20.

The sealing member 18b is for protecting the electro-optical element 12 and is disposed on the FPC board 13 so as to tightly seal the whole of the electro-optical element 12. Note that the sealing member 18b is formed to cover substantially the whole of the one surface side of the substrate 10b similarly to the first embodiment.

The manufacturing method according to the present embodiment is basically the same as the manufacturing method according to the first embodiment. Therefore, the description hereinafter is mainly focused on the differences between the two.

FIG. 6 illustrates various steps of a manufacturing method of the optical module according to the third embodiment. Firstly, as shown in FIG. 6a, a parent substrate 100 that will later be divided into the substrates 10b of respective optical modules 1b and the FPC board 13 are provided. As shown in FIG. 6b, the FPC board 13 is attached on the parent substrate 100. In the present embodiment, the FPC board 13 has a microstrip line.

Then, as shown in FIG. 6c, each of a plurality of electro-optical elements 12 is disposed in a respective one of the openings 20 of the FPC board 13, and then connected to the respective connection section 21. Then, the underfill members 17 for reducing the light loss is filled in between the electro-optical elements 12 and the connection sections 21. In this case, each of the electro-optical elements 12 is mounted on the respective connection section 21 with the light emitting or receiving surface thereof facing toward the substrate 10b. In the present process, the electro-optical element 12 is connected with the connection section 21 of the first interconnection layer 15 by flip-chip bonding. In the present process, since the openings 20 of the base member 14 are broader than the electro-optical elements 12, the electro-optical elements 12 are inserted into the openings 20. Other electronic components (for example, a driver for driving the electro-optical element 12) can be mounted on the FPC board 13 if required.

Then, as shown in FIG. 6d, the sealing members 18b are formed so that the whole of the electro-optical elements 12 is tightly sealed. As sealing member 18b, for example, thermosetting epoxy resin can be used. It is possible to form the sealing members 18b and the underfill members 17 in a batch from the same material.

Then, as shown in FIG. 6f, the parent substrate 100 and other necessary members are divided into predetermined pieces corresponding to the individual optical modules 1 b. Dicing or laser cutting can be used for the dividing process. Thus, a plurality of optical modules 11b can be obtained.

The optical module 1b according to the present embodiment can also be applied to an optical transceiver or various electronic devices as well.

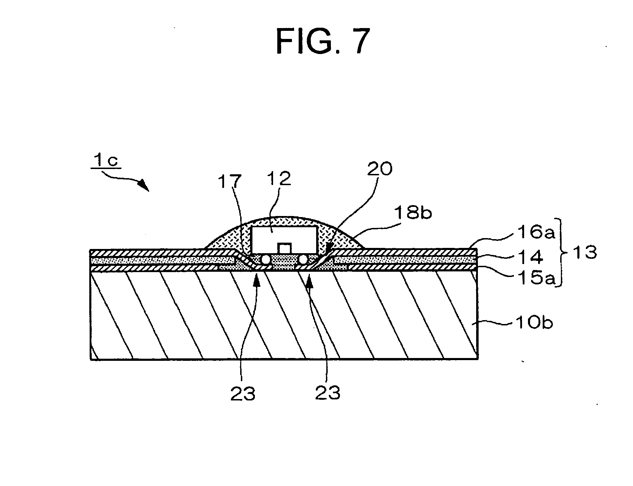

FIG. 7 is a schematic view showing another configuration of an optical module. The optical module 1c shown in the figure is formed by changing the layout of the connection section of the optical module 1b according to the third embodiment. More specifically, in the optical module 1c shown in FIG. 7, the connection section 23 is formed by exposing through the opening 20 a part of the second interconnection layer 16 disposed on the other surface side of the FPC board 13, the other surface side not contacting with the substrate 10b. The electro-optical element 12 is connected to the connection section 23. Note that in the first and second embodiments, a similar or the same structure can be adopted.

Further, as the electro-optical element in each embodiment, multiple light source device (such as an VCSEL array) or multiple light sensor device (such as a photodiode array) may be used, and a multichannel (multi-core) tape fiber or the like may used as the optical fiber, thus realizing an optical module suitable for a parallel transfer application.

Various embodiments of the optical module according to the present invention have been described hereinabove, but the scope of the present invention is not limited to these embodiments, and various modifications are possible within the scope of the appended claims.

## Claims

1. An optical module adapted to be detachably connected to an optical fiber (2), comprising:
a substrate (10) with an aperture (11) for receiving the optical fiber (2);
a flexible printed circuit board (13) disposed on one surface side of the substrate (10) and comprising:
a base member (14) with an opening (20) in a location corresponding to the aperture (11);
an interconnection layer (15, 16) at least on one surface side of the base member (14); and
a connection section (21) comprising a part of the interconnection layer (15, 16) exposed through the opening (20); and
an electro-optical element (12) disposed within the opening (20) of the printed circuit board (13) and electrically connected to the connection section (21) so as to perform transmission or reception of an optical signal through the optical fiber (2).

2. An optical module according to claim 1, further comprising an alignment member (17) interposed between an area defined by the aperture (11) and the electro-optical element (12) and for suppressing dispersion of the optical signal.

3. An optical module according to claim 1 or 2, further comprising a seal member (18) for tightly sealing the electro-optical element (12).

4. An optical module according to claim 3 wherein the seal member (18) and the alignment member (17) are made of the same material.

5. An optical module according to any one of claims 1 through 4 wherein the printed circuit board (13) comprises a microstrip line.

6. An optical module comprising:
a substrate (10a) with an aperture (11 a);
a flexible printed circuit board (13) on one surface side of the substrate (10a) and comprising:
a base member (14) with an opening (20) in a location corresponding to the aperture (11);
an interconnection layer (15, 16) at least on one surface side of the base member (14); and
a connection section (21) comprising a part of the interconnection layer (15, 16) exposed through the opening (20); and
an electro-optical element (12) disposed inside the aperture (11 a) and within the opening (20) of the printed circuit board (13), the electro-optical element (12) being electrically connected to the connection section (21) and adapted to perform transmission or reception of an optical signal through the printed circuit board (13).

7. An optical module comprising:
a substrate (10b) having transparency;
a printed circuit board (13) disposed on one surface side of the substrate (10b) and comprising:
a base member (14) with an opening (20);
an interconnection layer (15, 16) at least on one surface side of the base member (14); and
a connection section (21) comprising a part of the interconnection layer (15, 16) exposed through the opening (20); and
an electro-optical element (12) disposed within the opening (20) of the printed circuit board (13) and electrically connected to the connection section (21), the electro-optical element (12) being adapted to perform transmission or reception of an optical signal through the printed circuit board (13) and the substrate (10b).

8. An optical communication device comprising an optical module according to any of claims 1 through 7.

9. An electronic device comprising an optical module according to any of claims 1 through 7.

10. A method of manufacturing an optical module adapted to be detachably connected to an optical fiber (2), comprising:
a) boring, in a substrate (100), an aperture (11) adapted to receive the optical fiber (2) therein;
b) mounting a printed circuit board (13) on one surface side of the substrate (100), the printed circuit board (13) comprising a base member (14) with an opening (20), an interconnection layer (15, 16) at least on one surface side of the base member (14), and a connection section (21) comprising a part of the interconnection layer (15, 16) exposed through the opening (20), so that the opening (20) is in registration with the aperture (11); and
c) disposing an electro-optical element (12) in the opening (20) of the printed circuit board (13) and electrically connecting it to the connection section (21), the electro-optical element (12) being adapted to perform transmission or reception of an optical signal through the optical fiber (2).

11. A method according to claim 10, further comprising forming an alignment member (17) for suppressing dispersion of the optical signal between an area defined by the aperture (11) and the electro-optical element (12).

12. A method according to any of claims 10 through 12, further comprising forming a sealing member (18) so that the sealing member covers the electro-optical element (12).

13. A method of manufacturing an optical module, comprising:
a) boring an aperture (11 a) in a substrate (100) in which a component is disposed;
b) mounting a printed circuit board (13) on one surface side of the substrate (100), the printed circuit board (13) comprising a base member (14) with an opening (20), an interconnection layer (15, 16) at least on one surface side of the base member (14), and a connection section (21) comprising a part of the interconnection layer (15, 16) exposed through the opening (20), so that the opening (20) is in registration with the aperture (11 a); and
c) disposing an electro-optical element (12) inside the aperture (11a) and in the opening (20) of the printed circuit board (13) and electrically connecting it to the connection section (21) thereof so that a light emission or light reception surface of the electro-optical element (12) faces the printed circuit board (13).

14. A method according to any one of claims 10 through 13, wherein:
step a) comprises boring a plurality of said apertures (11; 11 a) in said substrate (100);
step b) comprises mounting a printed circuit board (13) that has a plurality of said openings (20) and a plurality of said connection sections (21), so that each opening (20) is in registration with a respective one of the apertures (11; 11 a);
step c) comprises disposing an electro-optical element (12) in each of the openings (20) of the printed circuit board (13) and connecting it to the respective connection section (21); and
the method comprises the further step, following step c), of dividing the substrate (100) into predetermined pieces each corresponding to a respective one of the apertures (11; 11 a) so as to obtain a plurality of said optical modules.

15. A method of manufacturing an optical module, comprising:
a) providing a substrate (100) having transparency;
b) mounting a printed circuit board (13) on one surface side of the substrate (100), the printed circuit board (13) comprising a base member (14) with an opening (20), an interconnection layer (15, 16) at least on one surface side of the base member (14), and a connection section (21) comprising a part of the interconnection layer (15, 16) exposed through the opening (20); and
c) disposing an electro-optical element (12) in the opening (20) of the printed circuit board (13) and electrically connecting it to the connection section (21) thereof, so that a light emission or light reception surface of electro-optical element (12) faces the printed circuit board (13).
